# FASCICULE DE BREVET EUROPEEN

(11) **EP 0 332 499 B1**
(45) Date de publication et mention de la délivrance du brevet: **24.03.1993**
(21) Numéro de dépôt: 89400550.3
(22) Date de dépôt: 28.02.1989
(51) Int. Cl.: H03K 3/288, H03K 3/356

(54) **Comparateur rapide avec étage de sortie fonctionnant en deux phases**
Schneller Komparator mit in zwei Phasen arbeitender Ausgangsstufe
Fast comparator with an output stage operating in two phases

(30) Priorité: 04.03.1988 FR 8802760
(43) Date de publication de la demande: 13.09.1989
(73) Titulaire: THOMSON COMPOSANTS MILITAIRES ET SPATIAUX, 75008 Paris (FR)
(72) Inventeur: Masson, Thierry, F-92045 Paris La Défense cedex 67 (FR)
(74) Mandataire: Guérin, Michel

(56) Documents cités:
- JP-A- 6 070 816
- US-A- 4 670 675
- PATENT ABSTRACTS OF JAPAN, vol. 9, no. 208 (E-388)[1931], 24 août 1985, page 15 E 338; & JP-A-60 70 816 (HITACHI SEISAKUSHO K.K.) 22-04-1985
- IEEE JOURNAL OF SOLID-STATE CIRCUITS, vol. SC-18, no. 3, juin 1983, pages 359-364, IEEE, New York, US; A.D. WELBOURN et al.: "A high speed GaAs 8 bit multiplexer using capacitor-coupled logic"

## Description

L'invention concerne les comparateurs, c'est-à-dire des amplificateurs à très grand gain fournissant un niveau logique soit haut soit bas selon que la tension différentielle entre leurs deux entrées est légèrement positive ou légèrement négative.

Dans certaines applications, telles que par exemple les convertisseurs analogiques-numériques, il est nécessaire d'utiliser des comparateurs fonctionnant très rapidement; c'est le cas par exemple dans les convertisseurs analogique-numérique de type à approximation successive dans lesquels on utilise un comparateur qui exécute un cycle de plusieurs comparaisons successives (autant qu'il y a de bits dans la valeur numérique de sortie du convertisseur) pour effectuer une conversion. On ne peut pas commencer une conversion suivante avant que la première ne soit complètement terminée.

On conçoit par conséquent l'importance qu'il y a à utiliser un comparateur très rapide.

Par ailleurs le gain doit être très élevé, sans quoi la précision du comparateur est mauvaise car il n'est pas capable de basculer franchement comme il le faudrait dès l'apparition d'un petit écart de potentiel entre ses entrées.

Enfin, comme c'est le cas dans beaucoup d'applications, et tout particulièrement dans la réalisation de circuits-intégrés, il est important d'une part que le comparateur ne soit pas trop encombrant et d'autre part qu'il ne consomme pas trop de puissance.

Malheureusement, ces caractéristiques de vitesse, de gain, de consommation, d'encombrement, et d'autres encore, sont très souvent contradictoires entre elles. Par exemple on augmente le gain en mettant plusieurs étages d'amplification en cascade, mais on détériore alors à la fois la vitesse, l'encombrement, et la consommation de puissance.

La présente invention a pour but de proposer un schéma de comparateur très intéressant du point de vue de la vitesse, du gain, de l'encombrement et de la puissance consommée.

On part d'un schéma de comparateur ayant deux entrées différentielles et deux branches de sortie différentielles comportant chacune un transistor de charge et un transistor de contre-réaction, le transistor de charge de l'une des branches étant relié entre une source de tension d'alimentation et la sortie de cette branche, et le transistor de contre-réaction de cette branche étant relié en parallèle sur le transistor de charge de la branche mais ayant une électrode de commande reliée à la sortie de l'autre branche.

Selon l'invention, on prévoit un moyen pour rendre l'action du transistor de charge prépondérante devant l'action du transistor de contre-réaction dans une première phase d'un cycle de comparaison, et pour rendre au contraire l'action du transistor de contre-réaction prépondérante devant l'action du transistor de charge dans une deuxième phase du cycle, le transistor de contre-réaction restant actif pendant la première phase.

Ce que l'on entend par action prépondérante est la chose suivante: s'il n'y avait pas de transistor de contre-réaction mais seulement un transistor de charge, le circuit différentiel se comporterait d'une certaine manière (par exemple en simple amplificateur de tension); s'il n'y avait pas de transistor de charge mais seulement un transistor de contre-réaction, il se comporterait d'une autre manière (par exemple en bascule bistable); s'il y à la fois un transistor de charge et un transistor de contre-réaction, le circuit se comportera en fonction de celui des deux qui a une action prépondérante (et cela dépendra soit de la taille des transistors, soit d'une action spécifique exercée sur ces transistors).

Selon l'invention, on exercera une action spécifique sur les branches de sortie du comparateur pour rendre prépondérante alternativement l'action du transistor de charge puis l'action du transistor de contre-réaction.

On notera qu'on connaît d'après le brevet JP-A-60-70816 un amplificateur à deux branches à deux transistors chacune, qui peut fonctionner alternativement en amplicateur et en bascule bistable, au cours de deux phases successives. Il n'y a pas de transistor de contre-réaction dans la phase d'amplification.

Dans un exemple de réalisation, on prévoit un transistor auxiliaire pour chaque branche, le transistor auxiliaire étant connecté entre une électrode de commande du transistor de charge de cette branche et la sortie de la branche, un moyen de commande de conduction des transistors auxiliaires étant prévu pour les rendre conducteurs dans une première phase de la comparaison et pour les bloquer dans une deuxième phase.

Ainsi, dans une première phase, le comparateur se comporte comme un amplificateur à gain moyennement élevé, et le potentiel des sorties varie dans un sens correspondant au sens de l'écart de tension différentielle entre ses entrées; mais dans une deuxième phase, il se comporte complètement comme une bascule bistable et bascule très rapidement, et avec un gain très élevé, dans le sens où il avait commencé à basculer à la première phase. En effet, dans la deuxième phase, seuls les transistors de contre-réaction, montés en bascule bistable puisque chacun est commandé par la sortie de l'autre branche, constituent vraiment la charge des branches de l'amplificateur.

Dans une variante de réalisation, on peut prévoir en outre que deux transistors supplémentaires sont prévus, un dans chaque branche, commandés en opposition de phase avec le transistor auxiliaire de la même branche. Ces transistors sont connectés entre la source d'alimentation et l'électrode de commande du transistor de charge de la branche considérée. Ils servent à bloquer plus franchement les transistors de charge dans la deuxième phase de la comparaison.

On peut envisager d'autres réalisations dans lesquelles par exemple le transistor de charge est en série avec un transistor supplémentaire, conducteur pendant la première phase et bloqué pendant la seconde, le transistor de contre-réaction étant en parallèle sur cet ensemble en série.

D'autres caractéristiques et avantages de l'invention apparaîtront à la lecture de la description détaillée qui suit et qui est faite en référence aux dessins annexés dans lesquels:
- la figure 1 représente un type d'étage de comparateur déjà expérimenté par la Demanderesse;
- la figure 2 représente un schéma de comparateur inspiré de celui de la figure 1 et incluant le perfectionnement selon l'invention.

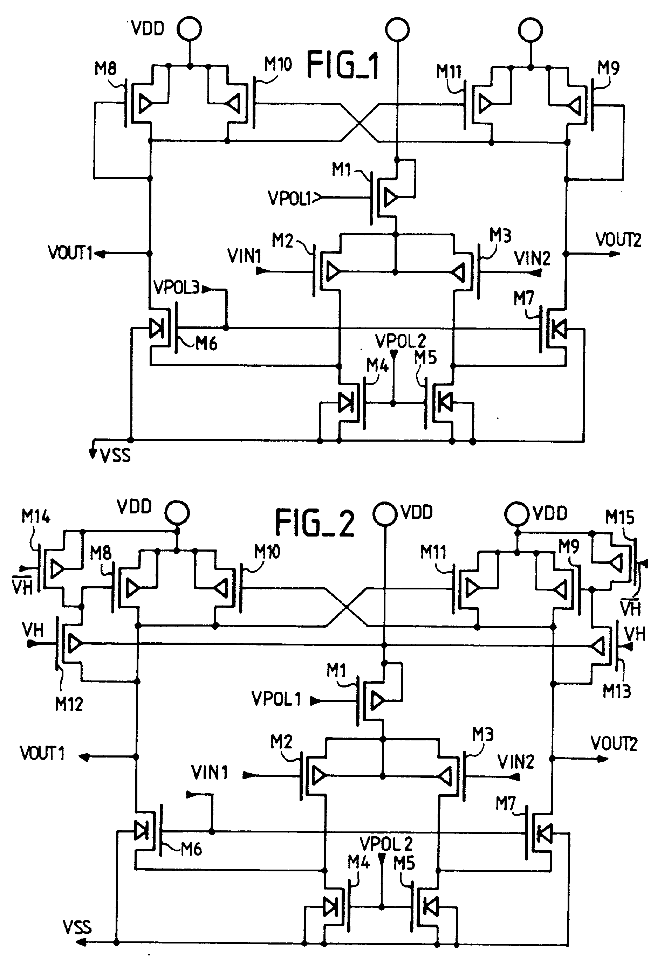

Le circuit à partir duquel a été conçu la présente invention est représenté à la figure 1. Il est réalisé en technologie CMOS et comprend donc à la fois des transistors à canal N et des transistors à canal P.

Le circuit de la figure 1 est un étage amplificateur différentiel à gain en tension de valeur moyenne (environ 30 à 50). Cela veut dire que si on désirait s'en servir pour faire un comparateur à gain élevé (par exemple 10 000) il faudrait utiliser trois étages en cascade. L'encombrement et la consommation de surface seraient très importants.

Le circuit de la figure 1 se divise en deux parties essentielles qui sont d'une part un étage d'entrée différentiel classique à cinq transistors (M1, M2, M3, M4, M5), et d'autre part un étage de sortie différentiel à six transistors (M6, M7, M8, M9, M10, M11).

L'étage concerné par la présente invention est l'étage de sortie mais on va d'abord expliquer le montage de l'étage d'entrée donné à titre d'exemple.

L'étage d'entrée comprend une source de courant constant constituée par un transistor MOS M1 (ici à canal P) ayant sa source reliée à une source de tension d'alimentation VDD et sa grille de commande polarisée par une tension fixe VPOL1.

Le drain du transistor M1 constitue la sortie de la source de courant et il alimente deux branches différentielles comportant chacune un transistor d'entrée (M2 pour la première branche, M3 pour la deuxième) en série avec un transistor de charge (M4 pour la première branche et M5 pour la deuxième).

Les transistors d'entrée, reliés, par leur source au transistor M1, sont des transistors à canal P et leurs grilles sont reliées chacune à une entrée différentielle respective (VIN1 pour la première, VIN2 pour la seconde) de l'étage amplificateur; les transistors de charge sont des transistors à canal N, leurs grilles sont portées à un potentiel de polarisation fixe VPOL2, et leur source est reliée à une borne de masse VSS (référence de potentiel bas).

Les sorties de l'étage d'entrée à cinq transistors sont prises l'une au point de jonction des transistors M2 et M4 et l'autre au point de jonction des transistors M3 et M5.

L'étage de sortie a deux entrées différentielles qui sont les sorties de l'étage d'entrée. Il est constitué de deux branches différentielles symétriques comportant chacune un transistor d'entrée et une charge. L'invention concerne plus spécialement la charge mais on va d'abord expliquer le montage du transistor d'entrée de l'exemple de réalisation décrit.

Le transistor d'entrée est monté selon une construction connue sous le nom de montage "cascode" dans lequel l'entrée se fait non pas sur la grille du transistor mais sur sa source.

Pour la première branche différentielle de l'étage de sortie, le transistor en montage cascode est un transistor M6 à canal N; pour la deuxième branche le transistor en montage cascode est un transistor M7 à canal N.

La source du transistor M6 est reliée au point de jonction entre les transistors M2 et M4, c'est à dire à une première sortie différentielle de l'étage d'entrée. De même, la source du transistor M7 est reliée à l'autre sortie de l'étage d'entrée, c'est-à-dire au point de jonction des transistors M3 et M5.

Les grilles des transistors M6 et M7 sont portées à un potentiel de polarisation fixe VPOL3.

Le drain du transistor M6 est relié à une première sortie de l'amplificateur (désignée par VOUT1 sur la figure 1), et également à une charge connectée par ailleurs à la source d'alimentation VDD. L'ensemble de ce transistor et de la charge correspondante forme la première branche différentielle de l'étage de sortie.

De même, le drain du transistor M7 est relié à une deuxième sortie de l'amplificateur (désignée par VOUT2 sur la figure 1), et également à une charge connectée par ailleurs à la source d'alimentation VDD. L'ensemble de ce transistor et de la charge correspondante forme la deuxième branche différentielle de l'étage de sortie.

Les charges de l'étage de sortie sont constituées chacune par deux transistors. L'un est un transistor de charge proprement dit, M8 pour la première branche, M9 pour la deuxième. L'autre est un transistor de contre-réaction positive (M10 pour la première branche, M11 pour la deuxième), dont la fonction est d'accroître l'augmentation de tension de sortie d'une branche proportionnellement à la diminution de la tension de sortie de l'autre branche, sans toutefois transformer l'amplificateur en bascule bistable.

Le transistor de charge est un transistor à canal P ayant sa source reliée à la source de tension VDD, son drain relié à la sortie de la branche correspondante, et sa grille reliée aussi à cette sortie.

Le transistor de contre-réaction est monté en parallèle sur le transistor de charge (leur source est commune et leur drain est commun), mais sa grille est commandée par la sortie de l'autre branche. Par conséquent, le transistor de contre-réaction M10 de la première branche, en parallèle sur le transistor de charge M8 de cette première branche, a sa grille commandée par la sortie VOUT2 de la deuxième branche. Le montage de la deuxième branche est symétrique.

L'amplificateur ainsi décrit fonctionne de la manière suivante: si une tension différentielle non nulle est appliquée entre les entrées VIN1 et VIN2, il en résulte un déséquilibre de courant dans les transistors M2 et M3, comme cela est bien connu. Le courant qui circule dans le transistor M2 est I+i et le courant dans le transistor M3 est I-i.

L'écart de courant circule dans les transistors cascode M6 et M7 car le courant dans les transsitors M4 et M5 est fixé par leur polarisation grille-source constante.

Le courant qui circulait dans le transistor M6 s'accroît de i tandis que le courant qui circulait dans le transistor M7 décroît de i.

Les transistors de charge M8 et M9 convertissent ces variations de courant en variations de tension que l'on retrouve donc sur les sorties différentielles VOUT1 et VOUT2.

L'amplificateur fonctionne même si les transsitors de contre-réaction M10 et M11 sont absents, mais le gain est alors très faible : le rapport (VOUT1 - VOUT2)/(VIN1 - VIN2) n'excède guère 5 à 6.

C'est pourquoi on a imaginé d'augmenter le gain par l'adjonction des transistors de contre-réaction positive M10 et M11.

Le transistor M10 a un rapport largeur de canal sur longueur de canal (W/L) plus petit que le transistor M8 avec lequel il est en parallèle. La relation est la même entre les transistors M11 et M9. En d'autres mots, la transconductance du transistor M10 est inférieure à celle du transistor M8, et il en est de même pour les transitors M11 et M9.

Si on appelle R10 le rapport largeur de canal sur longueur de canal du transistor M10 et R8 le rapport correspondant pour le transistor M8, on peut dire que le gain de l'amplificateur, qui serait G0 sans transistor de contre-réaction, devient G0/(1 - R10/R8) avec le transistor de contre-réaction.

R10/R8 est inférieur à 1, ce qui veut dire que la contre-réaction est inférieure à l'unité et qu'on ne transforme pas l'amplificateur en bascule bistable.

Mais on choisit R10 suffisamment proche de R8 (par exemple 80 à 90% de R8) pour multiplier le gain dans un rapport pouvant être de 5 à 10.

On aboutit ainsi à un amplificateur de gain 30 à 50 grâce à cette structure à un transistor de charge et un transistor de contre-réaction dans chaque branche, le transistor de charge ayant une action prépondérante sur celle du transistor de contre-réaction.

La figure 2 représente l'amélioration apportée par l'invention pour obtenir un amplificateur de gain beaucoup plus élevé, très rapide, et ne nécessitant pas la mise en cascade de plusieurs étages tels que celui de la figure 1.

Selon l'invention, on propose de faire fonctionner le comparateur en deux phases successives, la première correspondant au fonctionnement qui vient d'être expliqué, et la suivante consistant à rendre prépondérante l'action du transistor de contre-réaction par rapport à celle du transistor de charge.

Dans l'exemple décrit à la figure 2, on rajoute au schéma de la figure 1 un transistor auxiliaire M12 et un transistor auxiliaire M13; leur mise en conduction est commandée par une horloge dans une première phase d'un cycle de comparaison à deux phases, et leur blocage est commandé par l'horloge dans une deuxième phase de ce cycle.

Le transistor M12 est inséré dans la connection entre la grille du transistor M8 et la sortie VOUT1 de la première branche, de sorte que cette grille est reliée à la sortie VOUT1 pendant la première phase du cycle et qu'elle en est isolée pendant la deuxième phase; le transistor M13 est de même inséré dans la connection entre la grille du transistor M9 et la sortie VOUT2 de la deuxième branche, de sorte que cette grille est reliée à la sortie VOUT2 pendant la première phase et qu'elle en est isolée pendant la deuxième phase.

Sur la figure 2, le signal d'horloge est indiqué par VH. Si les transistors M12 et M13 sont à canal P, comme cela est représenté, la première phase d'horloge correspond à un niveau logique bas et la deuxième à un niveau haut (en logique positive).

Le fonctionnement du circuit sera décrit ci-dessous, mais on peut déjà dire que ce fonctionnement est amélioré si on prévoit en outre deux transistors supplémentaires, M14 et M15, reliés l'un entre la grille du transistor M8 et la source d'alimentation VDD et l'autre entre la grille du transistor M9 et la source VDD, ces deux transistors étant rendus conducteurs et bloqués en opposition de phase avec les transistors auxiliaires M12 et M13.

Dans la première phase d'un cycle de comparaison, les transistors M12 et M13 sont conducteurs et les transistors M14 et M15 sont bloqués. Le circuit est équivalent à celui de la figure 1; il se comporte comme un amplificateur à gain moyen (environ 30 à 50 grâce à la contre-réaction positive).

Dans la deuxième phase du cycle, on bloque les transistors M12 et M13, ce qui isole les grilles des transisors de charge M8 et M9. La conductance de ces transistors devient très faible et tout se passe comme si ces transistors de charge étaient supprimés ou remplacés par des résistances de valeur élevée. La contre-réaction positive par les transistors M10 et M11 devient prépondérante et l'étage de sortie se comporte complètement comme une bascule bistable et non comme un amplificateur. Les sorties VOUT1 et VOUT2 de l'amplificateur basculent très rapidement dans un état logique dicté par le sens de variation de tension de ces sorties au cours de la première phase du cycle.

Le circuit qui fonctionnait comme amplificateur à gain moyen au cours de la première phase fonctionne comme comparateur à gain très élevé au cours de la deuxième phase. Lorsqu'on repasse à une première phase d'un nouveau cycle de comparaison, les transistors M12 et M13 sont à nouveau rendus conducteurs pour revenir à une configuration d'amplificateur à gain moyen (sans quoi le comparateur ne pourrait pas rebasculer dans un autre état).

La mise en conduction des transistors supplémentaires M14 et M15 au moment du blocage des transistors M12 et M13 permet d'accélérer le blocage des transistors de charge M8 et M9 au début de la deuxième phase en portant la grille de ces transistors de charge au potentiel haut VDD.

On peut noter que les fronts de commutation générés par l'horloge VH n'engendrent pas de parasites sur la sortie VOUT1, VOUT2 si on sort en différentiel entre ces deux sorties.

L'invention permet donc de réaliser un comparateur très rapide et à très grand gain, avec un seul étage (comportant quatre transistors de plus que celui de la figure 1 et une horloge de commutation).

On peut par exemple détecter un écart de tension de 0,1 millivolt entre les entrées VIN1 et VIN2 en un cycle de moins de 70 nanosecondes.

Ce comparateur est très intéressant à utiliser dans des circuits où des cycles de comparaisons doivent être exécutés en un temps court sous le contrôle d'une horloge. C'est le cas par exemple dans des convertisseurs analogique-numérique à réseaux de capacités commutés : il est facile de prévoir une horloge synchronisée avec les signaux de commutation de capacités pour engendrer les deux phases du cycle de comparaison nécessaires dans le comparateur selon l'invention.

## Revendications

1. Comparateur à grand gain et grande vitesse, ayant deux entrées différentielles (VIN1, VIN2 ) et deux branches de sortie différentielles comportant chacune un transistor de charge (M8, M9) et un transistor de contre-réaction (M10, M11), le transistor de charge de l'une des branches étant relié entre une source de tension d'alimentation (VDD) et la sortie (VOUT1, VOUT2) de cette branche, et le transistor de contre-réaction de cette branche étant relié en parallèle sur le transistor de charge de la branche mais ayant une électrode de commande reliée à la sortie de l'autre branche, caractérisé en ce qu'il est prévu un moyen (M12, M13, M14, M15) pour rendre l'action du transistor de charge prépondérante devant l'action du transistor de contre-réaction dans une première phase d'un cycle de comparaison, et pour rendre au contraire l'action du transistor de contre-réaction prépondérante devant l'action du transistor de charge dans une deuxième phase du cycle, le transistor de contre-réaction restant actif pendant la première phase.

2. Comparateur selon la revendication 1, caractérisé en ce qu'il comporte un transistor auxiliaire (M12, M13) pour chaque branche, le transistor auxiliaire étant connecté entre une électrode de commande du transistor de charge (M8, M9) de cette branche et la sortie de cette branche (VOUT1, VOUT2), un moyen de commande de conduction des transistors auxiliaires étant prévu pour les rendre conducteurs dans une première phase de la comparaison et pour les bloquer dans une deuxième phase.

3. Comparateur selon la revendication 2, caractérisé en ce qu'il est prévu en outre deux transistors supplémentaires (M14, M15), un dans chaque branche, commandés en opposition de phase avec le transistor auxiliaire de la même branche, ces transistors étant connectés entre la source d'alimentation et l'électrode de commande du transistor de charge de la branche considérée

4. Comparateur selon la revendication 1, caractérisé en ce que le transistor de charge est en série avec un transistor supplémentaire, conducteur pendant la première phase et bloqué pendant la seconde, le transistor de contre-réaction étant en parallèle sur cet ensemble en série.

## Patentansprüche

1. Komparator hoher Verstärkung und hoher Geschwindigkeit, der zwei Differenzeingänge (VIN1, VIN2) und zwei Differenzausgangszweige aufweist, von denen jeder einen Lasttransistor (M8, M9) und einen Rückkopplungstransistor (M10, M11) aufweist, wobei der Lasttransistor des einen Zweigs zwischen eine Versorgungsspannungsquelle (VDD) und den Ausgang (VOUT1, VOUT2) dieses Zweigs geschaltet ist, und der Rückkopplungstransistor dieses Zweigs parallel zum Lasttransistor des Zweigs geschaltet ist, jedoch eine Steuerelektrode aufweist, die mit dem Ausgang des anderen Zweigs verbunden ist, dadurch gekennzeichnet, daß ein Mittel (M12, M13, M14, M15) vorgesehen ist, um in einer ersten Phase eines Vergleichszyklus die Wirkung des Lasttransistors gegenüber der Wirkung des Rückkopplungstransistors vorherrschend zu machen und um in einer zweiten Phase des Zyklus im Gegensatz hierzu die Wirkung des Rückkopplungstransistors gegenüber der Wirkung des Lasttransistors vorherrschend zu machen, wobei der Rückkopplungstransistor während der ersten Phase aktiv bleibt.

2. Komparator nach Anspruch 1, dadurch gekennzeichnet, daß er einen Hilfstransistor (M12, M13) in jedem Zweig aufweist, welcher Hilfstransistor zwischen eine Steuerelektrode des Lasttransistors (M8, M9) dieses Zweigs und den Ausgang dieses Zweigs (VOUT1, VOUT2) geschaltet ist, und ein Leitfähigkeitssteuermittel für die Hilfstransistoren vorgesehen ist, um diese in einer ersten Phase des Vergleichs leitend zu schalten und um sie in einer zweiten Phase zu sperren.

3. Komparator nach Anspruch 2, dadurch gekennzeichnet, daß ferner zwei Zusatztransistoren (M14, M15) vorgesehen sind, einer in jedem Zweig, die gegenphasig zum Hilfstransistor desselben Zweigs gesteuert werden, welche Transistoren zwischen die Versorgungsquelle und die Steuerelektrode des Lasttransistors des jeweiligen Zweigs geschaltet sind.

4. Komparator nach Anspruch 1, dadurch gekennzeichnet, daß der Lasttransistor in Reihe mit einem Hilfstransistor liegt, der während der ersten Phase leitet und während der zweiten sperrt, wobei der Rückkopplungstransistor parallel zu dieser Reihenschaltung liegt.

## Claims

1. Large-gain, high-speed comparator having two differential inputs (VIN1, VIN2) and two differential output branches each including a load transistor (M8, M9) and a negative feedback transistor (M10, M11), the load transistor of one of the branches being joined between a supply voltage source (VDD) and the output (VOUT1, VOUT2) of this branch, and the negative feedback transistor of this branch being joined in parallel with the load transistor of the branch but having a control electrode joined to the output of the other branch, characterised in that a means (M12, M13, M14, M15) is provided for making the action of the load transistor predominant relative to the action of the negative feedback transistor in a first phase of a comparison cycle, and for making on the contrary the action of the negative feedback transistor predominant relative to the action of the load transistor in a second phase of the cycle, the negative feedback transistor remaining active during the first phase.

2. Comparator according to Claim 1, characterised in that it includes an auxiliary transistor (M12, M13) for each branch, the auxiliary transistor being connected between a control electrode of the load transistor (M8, M9) of this branch and the output of this branch (VOUT1, VOUT2), a means of control of conduction of the auxiliary transistors being provided in order to make them conducting in a first phase of the comparison and in order to block them in a second phase.

3. Comparator according to Claim 2, characterised in that there are furthermore provided two supplementary transistors (M14, M15), one in each branch, controlled in phase opposition with the auxiliary transistor of the same branch, these transistors being connected between the supply source and the control electrode of the load transistor of the relevant branch.

4. Comparator according to Claim 1, characterised in that the load transistor is in series with a supplementary transistor, conducting during the first phase and blocked during the second, the negative feedback transistor being in parallel with this series assembly.
